# EUROPEAN PATENT APPLICATION

(11) **EP 4 471 441 A1**
(43) Date of publication of application: **04.12.2024**
(21) Application number: 23746161.1
(22) Date of filing: 18.01.2023
(51) Int. Cl.: G01R 31/387, G01R 31/382

(54) **METHOD FOR DETERMINING SOC AVAILABLE WINDOW VALUE OF BATTERY, AND RELATED APPARATUS**

(30) Priority: 28.01.2022 CN 202210105957
(71) Applicant: Great Wall Motor Company Limited, Baoding, Hebei 071000 (CN)
(72) Inventor: KANG, Wenrong, Baoding, Hebei 071000 (CN); WANG, Yin, Baoding, Hebei 071000 (CN); ZHANG, Junwei, Baoding, Hebei 071000 (CN)
(74) Representative: Klunker IP Patentanwälte PartG mbB
(86) International application number: PCT/CN2023/072775
(87) International publication number: WO 2023/143279

(57) **Abstract**

A method for determining an available SOC window value of a battery and a relevant apparatus, wherein the method includes: calculating a corresponding power value when the battery discharges to a cut-off voltage, and using the power value as a target power value (S101); and looking up a minimum SOC value corresponding to the target power value in a first minimum-power pulse-spectrum chart, and using the minimum SOC value as the available SOC window value (S102). The method can increase the releasable electric quantity of the battery while ensuring the safety of the battery, to improve the endurance capacity of the battery, and optimize the user experience.

## Description

The present application claims the priority of the Chinese patent application filed on January 28th, 2022 with the application number of CN 202210105957.7. The disclosure of the earlier application is incorporated herein in its entirety by reference.

### TECHNICAL FIELD

The present application relates to the technical field of batteries, and particularly to a method for determining an available SOC window value of a battery and a relevant apparatus.

### BACKGROUND

The available window value of the SOC (State Of Charge, used to reflect the residual capacity of a battery) of a battery is an important parameter of the battery, and represents the state of the capacity of discharging of the battery at that temperature. When the actual SOC value of the battery is less than the available SOC window value, it may be considered that the battery is in a no-electricity state, and safety measures such as power limitation are required to be performed to the battery, to prevent over discharge of the battery while ensuring supplying the sufficient electric quantity to the user, wherein the over discharge refers to continuous discharging after the battery has released the internally stored electric quantity and the voltage has reached a certain value.

Currently, the available SOC window value of the battery is obtained usually by calculation by using the quotient of the unusable capacity (i.e., the difference between the rated capacity and the maximum available capacity) of the battery and the rated capacity of the battery, wherein the maximum available capacity refers to the whole of the capacity value that can be released when, at a certain temperature, a full-electricity battery pack continuously discharges with the electric current at a discharge rate of C/3 (one third of the rated capacity of the battery) till the battery voltage is the discharging cut-off voltage. The inventor has found that, after the maximum available capacity has been completely used, although the battery cannot continue continuously discharging with the constant electric current, it can still be used for a short duration, and if the available SOC window value calculated by using the maximum available capacity is directly used to control the battery to discharge, that causes that part of the available electric quantity cannot be released, which affects the endurance and the user experience.

### SUMMARY

The present application provides a method for determining an available SOC window value of a battery and a relevant apparatus, to solve the problem of affecting the endurance and the user experience by large available SOC window value of batteries.

In the first aspect, the present application provides a method for determining an available SOC window value of a battery, and the method includes:
calculating a corresponding power value when the battery discharges to a cut-off voltage, and using the power value as a target power value; and
looking up a minimum SOC value corresponding to the target power value in a first minimum-power pulse-spectrum chart, and using the minimum SOC value as the available SOC window value;
wherein the first minimum-power pulse-spectrum chart refers to a chart of a correspondence relation between SOC values and minimum powers, the minimum power corresponding to any one of the SOC values represents the minimum power with which the battery with that SOC value performs short-time discharging to cause a battery voltage to reach the cut-off voltage, and a time period of the short-time discharging is less than a preset duration.

In an alternative embodiment, the first minimum-power pulse-spectrum chart is acquired by:
acquiring a current temperature of the battery;
acquiring power pulse-spectrum charts corresponding to a plurality of electric-current impact durations of the battery, wherein each of the power pulse-spectrum charts includes a correspondence relation among temperatures, the SOC values and instantaneous powers;
using a minimum value of the instantaneous powers corresponding to the plurality of electric-current impact durations with respect to a same temperature and a same SOC value as the minimum power corresponding to that temperature and that SOC value, to obtain a minimum-power pulse-spectrum chart; and
looking up a correspondence relation between the SOC values and the minimum powers at the current temperature in the minimum-power pulse-spectrum chart, and using the correspondence relation between the SOC values and the minimum powers at the current temperature as the first minimum-power pulse-spectrum chart.

In an alternative embodiment, the instantaneous powers are acquired by:
when the battery is at a same temperature and a same SOC value, discharging the battery at a plurality of unequal powers for the plurality of electric-current impact durations, and using powers that are capable of impacting the battery voltage to a discharging cut-off voltage as the instantaneous powers corresponding to the plurality of electric-current impact durations at that temperature and that SOC value.

In an alternative embodiment, the first minimum-power pulse-spectrum chart is acquired by:
acquiring a current lowest temperature and a current highest temperature of the battery, wherein the current lowest temperature refers to a minimum value of current temperatures corresponding to a plurality of individual cells in the battery, and the current highest temperature refers to a maximum value of the current temperatures corresponding to the plurality of individual cells in the battery;
acquiring power pulse-spectrum charts corresponding to a plurality of electric-current impact durations of the battery, wherein each of the power pulse-spectrum charts includes a correspondence relation among temperatures, the SOC values and instantaneous powers;
for the instance of the power pulse-spectrum charts corresponding to each of the electric-current impact durations, looking up from that power pulse-spectrum chart a correspondence relation between the SOC values and the instantaneous powers at the current lowest temperature, and a correspondence relation between the SOC values and the instantaneous powers at the current highest temperature;
for each of the SOC values in that power pulse-spectrum chart, selecting a smaller value between the instantaneous power at the current highest temperature and the instantaneous power at the current lowest temperature corresponding to that SOC value, to be used as the minimum power corresponding to that SOC value in that power pulse-spectrum chart; and
using a minimum value among the minimum powers corresponding to a same SOC value in the plurality of power pulse-spectrum charts as the minimum power corresponding to that SOC value, to obtain the first minimum-power pulse-spectrum chart.

In an alternative embodiment, the step of calculating the corresponding power value when the battery discharges to the cut-off voltage, and using the power value as the target power value includes:
by using a formula *Pₘᵢₙ*=*Vⱼ***n***η*, calculating the target power value;
wherein *Pₘᵢₙ* represents the target power value, *Vⱼ* represents an individual cut-off voltage, *n* represents a quantity of individual cell strings included by the battery, and *η* represents a discharge rate.

In an alternative embodiment, before the step of calculating the corresponding power value when the battery discharges to the cut-off voltage, the method further includes:
acquiring a current temperature of the battery;
if the current temperature of the battery is in a normal-temperature interval, setting the available SOC window value of the battery to be zero; and
if the current temperature of the battery is not in the normal-temperature interval, executing the step of calculating the corresponding power value when the battery discharges to the cut-off voltage.

In an alternative embodiment, the step of looking up the minimum SOC value corresponding to the target power value in the first minimum-power pulse-spectrum chart, and using the minimum SOC value as the available SOC window value of the battery includes:
when a minimum power equal to the target power value is not capable to be found in the first minimum-power pulse-spectrum chart, selecting a SOC value corresponding to a minimum power that has a lowest difference from the target power value, to be used as the available SOC window value corresponding to the target power value.

In an alternative embodiment, the step of looking up in the first minimum-power pulse-spectrum chart the minimum SOC value corresponding to the target power value, and using the minimum SOC value as the available SOC window value of the battery includes:
when a minimum power equal to the target power value is not capable to be found in the first minimum-power pulse-spectrum chart, selecting an average value of the SOC values corresponding to two minimum powers adjacent to the target power value, to be used as the available SOC window value corresponding to the target power value.

In the second aspect, the present application provides an apparatus for determining an available SOC window value of a battery, and the apparatus includes:
a target-power-value calculating module configured for calculating a corresponding power value when the battery discharges to a cut-off voltage, and using the power value as a target power value; and
an available-SOC-window-value calculating module configured for looking up a minimum SOC value corresponding to the target power value in a first minimum-power pulse-spectrum chart, and using the minimum SOC value as the available SOC window value;
wherein the first minimum-power pulse-spectrum chart refers to a chart of a correspondence relation between SOC values and minimum powers, the minimum power corresponding to any one of the SOC values represents the minimum power with which the battery with that SOC value performs short-time discharging to cause a battery voltage to reach the cut-off voltage, and a time period of the short-time discharging is less than a preset duration.

In an alternative embodiment, the apparatus for determining an available SOC window value of a battery further includes a first-minimum-power-pulse-spectrum-chart acquiring module configured for:
acquiring a current temperature of the battery;
acquiring power pulse-spectrum charts corresponding to a plurality of electric-current impact durations of the battery, wherein each of the power pulse-spectrum charts includes a correspondence relation among temperatures, the SOC values and instantaneous powers;
using a minimum value of the instantaneous powers corresponding to the plurality of electric-current impact durations with respect to a same temperature and a same SOC value as the minimum power corresponding to that temperature and that SOC value, to obtain a minimum-power pulse-spectrum chart; and
looking up a correspondence relation between the SOC values and the minimum powers at the current temperature in the minimum-power pulse-spectrum chart, and using the correspondence relation between the SOC values and the minimum powers at the current temperature as the first minimum-power pulse-spectrum chart.

In an alternative embodiment, the first-minimum-power-pulse-spectrum-chart acquiring module is configured for:
acquiring a current lowest temperature and a current highest temperature of the battery, wherein the current lowest temperature refers to a minimum value of current temperatures corresponding to a plurality of individual cells in the battery, and the current highest temperature refers to a maximum value of the current temperatures corresponding to the plurality of individual cells in the battery;
acquiring power pulse-spectrum charts corresponding to a plurality of electric-current impact durations of the battery, wherein each of the power pulse-spectrum charts includes a correspondence relation among temperatures, the SOC values and instantaneous powers;
for the instance of the power pulse-spectrum charts corresponding to each of the electric-current impact durations, looking up from that power pulse-spectrum chart a correspondence relation between the SOC values and the instantaneous powers at the current lowest temperature, and a correspondence relation between the SOC values and the instantaneous powers at the current highest temperature;
for each of the SOC values in that power pulse-spectrum chart, selecting a smaller value between the instantaneous power at the current highest temperature and the instantaneous power at the current lowest temperature corresponding to that SOC value, to be used as the minimum power corresponding to that SOC value in that power pulse-spectrum chart; and
using a minimum value among the minimum powers corresponding to a same SOC value in the plurality of power pulse-spectrum charts as the minimum power corresponding to that SOC value, to obtain the first minimum-power pulse-spectrum chart.

In an alternative embodiment, the target-power-value calculating module is configured for:
by using a formula *Pₘᵢₙ*=*Vⱼ***n***η*, calculating the target power value;
wherein *Pₘᵢₙ* represents the target power value, *Vⱼ* represents an individual cut-off voltage, *n* represents a quantity of individual cell strings included by the battery, and *η* represents a discharge rate.

In an alternative embodiment, the apparatus further includes a temperature determining module configured for:
acquiring a current temperature of the battery;
if the current temperature of the battery is in a normal-temperature interval, setting the available SOC window value of the battery to be zero; and
if the current temperature of the battery is not in the normal-temperature interval, executing the functions of the target-power-value calculating module and the available-SOC-window-value calculating module.

In the third aspect, the present application provides an electronic device, including a memory, a processor, and a computer program that is stored in the memory and executable in the processor, wherein the processor, when executing the computer program, implements the steps of the method according to the alternative implementations of the first aspect.

In the fourth aspect, the present application provides a computer-readable storage medium, the computer-readable storage medium storing a computer program, wherein the computer program, when executed by a processor, implements the steps of the method according to any one of the alternative implementations of the first aspect.

In the fifth aspect, the present application provides a vehicle, wherein the vehicle includes the electronic device according to the third aspect.

The embodiments of the present application provide a method for determining an available SOC window value of a battery, it includes firstly calculating a corresponding power value when the battery discharges to the cut-off voltage, and using the power value as a target power value; and subsequently, looking up a minimum SOC value corresponding to the target power value in a first minimum-power pulse-spectrum chart, that SOC value is the residual capacity of the battery when discharging has been performed with that target power value till no charge can be further discharged, and using the minimum SOC value as the available SOC window value. Because the correspondence relation between the minimum powers and the SOC values in the minimum-power pulse-spectrum chart is determined by determining whether the battery, after short-time discharging with a certain SOC value with the minimum power, has reached the cut-off voltage, and the maximum available capacity refers to the whole electric quantity that can be released when, by using an electric-current of a constant discharge rate, the battery has been discharged continuously from the full-electricity state till the battery voltage reaches the discharging cut-off voltage, as compared with the method of calculating the available SOC window value based on the maximum available capacity, the method according to the present embodiment, by using the instantaneous power impact, generally can enable the battery to release more electric quantity. Therefore, in the present embodiment, the available SOC window value of the battery is obtained based on the first minimum-power pulse-spectrum chart, which can increase the releasable electric quantity of the battery while ensuring the safety of the battery, to improve the endurance capacity of the battery, and optimize the user experience.

### BRIEF DESCRIPTION OF THE DRAWINGS

In order to more clearly illustrate the technical solutions of the embodiments of the present application, the figures that are required to describe the embodiments or the prior art will be briefly described below. Apparently, the figures that are described below are embodiments of the present application, and a person skilled in the art can obtain other figures according to these figures without paying creative work.
FIG. 1 is a flow chart of the implementation of a method for determining an available SOC window value of a battery according to an embodiment of the present application;
FIG. 2 is a power pulse-spectrum chart according to an embodiment of the present application;
FIG. 3 is a schematic structural diagram of an apparatus for determining an available SOC window value of a battery according to an embodiment of the present application; and
FIG. 4 is a schematic diagram of an electronic device according to an embodiment of the present application.

### DETAILED DESCRIPTION

In the following description, in order for description rather than limitation, particular details such as particular system structures and techniques are provided, to facilitate to thoroughly comprehend the embodiments of the present application. However, a person skilled in the art should clearly know that the present application may also be embodied in the embodiments that do not have those particular details. In other cases, the detailed description on the well-known systems, devices, circuits and methods is omitted, to prevent affecting the description on the present application by unnecessary details.

In order to make the objects, the technical solutions and the advantages of the present application clearer, the present application will be described below with reference to the drawings and the particular embodiments.

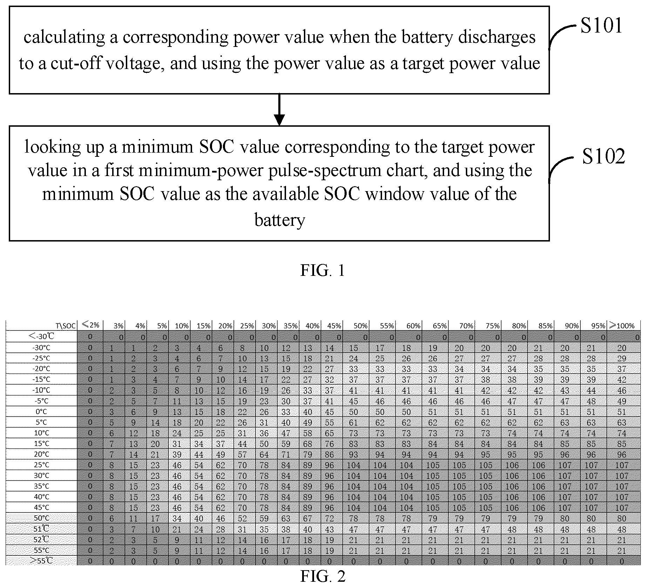

Referring to FIG. 1, FIG. 1 shows a process of the implementation of a method for determining an available SOC window value of a battery according to an embodiment of the present application. The subject of the implementation of the present embodiment (the electronic device) may be a battery managing system. It will be described in detail as follows:
S101: calculating a corresponding power value when the battery discharges to a cut-off voltage, and using the power value as a target power value.

Particularly, the power value used herein refers to the output power value of the battery, and the target power value refers to the output power value of the battery when the battery discharges to the cut-off voltage.

S102: looking up a minimum SOC value corresponding to the target power value in a first minimum-power pulse-spectrum chart, and using the minimum SOC value as the available SOC window value; wherein the first minimum-power pulse-spectrum chart refers to a chart of a correspondence relation between SOC values and minimum powers, wherein the minimum power corresponding to any one of the SOC values represents the minimum power with which the battery with that SOC value performs short-time discharging to cause a battery voltage to reach the cut-off voltage, wherein a time period of the short-time discharging is less than a preset duration.

Particularly, the inventor has found that, after the maximum available capacity of the battery has been completely used, although the residual electricity of the battery is insufficient to support continuous discharging with the electric current at the C/3 rate, it can still be used for a short duration. Therefore, in the practical usage of batteries, if the available SOC window value of the battery is calculated merely according to the maximum available capacity, and subsequently battery-power limitation is exerted on the user according to that value, that causes that part of the available electric quantity of the battery cannot be released, and thus cannot be used by the user.

In the present embodiment, a first minimum-power pulse-spectrum chart of the battery is employed to determine the available SOC window value.

Particularly, Table 1 shows a first minimum-power pulse-spectrum chart. As shown in Table 1, the first minimum-power pulse-spectrum chart includes the minimum powers corresponding to a plurality of SOC values in the full SOC range. The minimum power corresponding to each of the SOC values represents the minimum power that can enable the battery voltage to reach the discharging cut-off voltage when the battery undergoes short-time discharging with that SOC value. Furthermore, with the decreasing of the SOC value of the battery, the corresponding minimum power decreases accordingly. That is because, when the SOC value of the battery is higher, the internal resistance of the battery is lower, and a discharging with a higher electric current is required to impact the battery voltage to the cut-off voltage. Moreover, when the SOC value of the battery is lower, the internal resistance of the battery is higher, and a discharging with a lower electric current can impact the battery voltage to the cut-off voltage.

Particularly, the preset duration may be 200 seconds (s), and the time period in the short-time discharging may be set to be a time period less than 200s such as 10s, 20s, 30s, 50s and 100s.

**Table 1**

| | | | | | | | | | | | | | | |
|---|---|---|---|---|---|---|---|---|---|---|---|---|---|---|
| SOC value | 0 | 3 | 5 | 10 | 20 | 30 | 40 | 50 | 60 | 70 | 80 | 90 | 95 | 100 |
| Minimum power (KW) | 0 | 12.1 | 20.2 | 40.5 | 55.7 | 70.9 | 81.4 | 93.6 | 93.6 | 93.6 | 93.6 | 93.6 | 93.6 | 93.6 |

It can be known from Table 1 that the minimum powers corresponding to the unequal SOC values may be equal and may also be unequal. For example, in Table 1, the SOC values corresponding to the minimum power of 93.6KW are 50, 60, 70, 80, 90, 95 and 100. The battery managing system may use the first minimum-power pulse-spectrum chart to look up the corresponding SOC value when the minimum power is the target power value, and subsequently using the minimum value of the at least one obtained SOC value as the available SOC window value corresponding to that target power value.

As an example, if the target power value is 93.6KW, by looking up Table 1, it can be obtained that the corresponding available SOC window value is 50.

When a minimum power equal to the target power value cannot be found in the first minimum-power pulse-spectrum chart, the SOC value corresponding to the minimum power that has the lowest difference from the target power value may be selected, to be used as the available SOC window value corresponding to the target power value. The average value of the SOC values corresponding to two minimum powers adjacent to the target power value may also be selected, to be used as the available SOC window value corresponding to the target power value.

It can be known from the above embodiments that the method of calculating the available SOC window value according to the present embodiment is based on the first minimum-power pulse-spectrum chart, and the correspondence relation between the minimum powers and the SOC values in the first minimum-power pulse-spectrum chart is determined by determining whether the battery, after short-time discharging with a certain SOC value with the minimum power, has reached the cut-off voltage. Based on the physical characteristics of the battery, when the short-time discharging is performed to the battery with the minimum power, the formula of calculating the open-circuit voltage of the battery is U*_{ocv}*=U*_{c}*-I·DCR, wherein U*_{ocv}* represents the open-circuit voltage of the battery, U*_{c}* represents the measured voltage of the battery, I represents the output current of the battery, DCR represents the internal resistance of the battery, and I·DCR represents the ohmic voltage of the battery. However, in the prior art, the method of calculating the available SOC window value is determined based on the maximum available capacity, and the maximum available capacity refers to the whole electric quantity that can be released when, by using an electric-current of a constant discharge rate, the battery has been discharged continuously from the full-electricity state till the battery voltage reaches the discharging cut-off voltage. In long-time discharging, the formula of calculating the open-circuit voltage of the battery is U*_{ocv}*=U*_{c}*-I·DCR-U*ₕ*, wherein U*ₕ* represents the polarization voltage of the battery. By comparing the above formulas of calculating the open-circuit voltage corresponding to the two discharging modes, it can be known that, with the equal discharging power, the long-time discharging, because it has already activated the polarization voltage of the battery, more easily reduces the battery voltage to the cut-off voltage. In contrast, in short-time discharging, the discharging has already ended before the polarization voltage of the battery is activated out, and therefore the battery voltage is not easily reduced to the cut-off voltage. Therefore, as compared with the method of calculating the available SOC window value based on the maximum available capacity, the method according to the present embodiment, by using the instantaneous power impact, can enable the battery to release more electric quantity, and therefore the available SOC window value obtained by calculation by using the minimum-power pulse-spectrum chart is lower. The method can increase the releasable electric quantity of the battery while ensuring the safety of the battery, to improve the endurance capacity of the battery, and optimize the user experience.

In an alternative embodiment, the first minimum-power pulse-spectrum chart is acquired by:
S201: acquiring a current temperature of the battery;
S202: acquiring power pulse-spectrum charts corresponding to a plurality of electric-current impact durations of the battery, wherein each of the power pulse-spectrum charts contains a correspondence relation among temperatures, the SOC values and instantaneous powers;
S203: using a minimum value of the instantaneous powers corresponding to the plurality of electric-current impact durations with respect to a same temperature and a same SOC value as the minimum power corresponding to that temperature and that SOC value, to obtain a minimum-power pulse-spectrum chart; and
S204: looking up a correspondence relation between the SOC values and the minimum powers at the current temperature in the minimum-power pulse-spectrum chart, and using the correspondence relation between the SOC values and the minimum powers at the current temperature as the first minimum-power pulse-spectrum chart.

In the present embodiment, when a battery leaves factory, usually the power pulse-spectrum charts corresponding to a plurality of unequal electric-current impact durations are given. A power pulse-spectrum chart is shown in FIG. 2, and FIG. 2 shows the correspondence relation between the instantaneous powers, the temperatures and the SOC values with respect to a certain electric-current impact duration. Regarding a certain temperature and a certain SOC value in FIG. 2, the method of acquiring the instantaneous power corresponding to them includes: when the battery is at that temperature and that SOC value, discharging the battery at a plurality of unequal powers for the above electric-current impact duration, and using powers that are capable of impacting the battery voltage to the discharging cut-off voltage as the instantaneous powers corresponding to that temperature and that SOC value.

Particularly, the electric-current impact durations of the power pulse-spectrum charts are usually 10s, 30s and 100s. After the power pulse-spectrum charts corresponding to the plurality of electric-current impact durations have been obtained, the minimum-power pulse-spectrum chart is selected therefrom, wherein the minimum-power pulse-spectrum chart includes the temperatures, the SOC values and the minimum powers, and the correspondence relation among them. Because, when both of the battery temperature and the SOC value are constant, the usage of a lower power usually can release more electric quantity, the acquired minimum-power pulse-spectrum chart can obtain a lower available SOC window value, whereby the battery can more fully release the electric quantity that can be released.

After the minimum-power pulse-spectrum chart has been acquired, the first minimum-power pulse-spectrum chart can be looked up according to the current temperature of the battery.

As another alternative embodiment, the first minimum-power pulse-spectrum chart may also be obtained in the following process, which will be described in detail as follows:
S301: acquiring a current lowest temperature and a current highest temperature of the battery, wherein the current lowest temperature refers to a minimum value of current temperatures corresponding to a plurality of individual cells in the battery, and the current highest temperature refers to a maximum value of the current temperatures corresponding to the plurality of individual cells in the battery;
S302: acquiring power pulse-spectrum charts corresponding to a plurality of electric-current impact durations of the battery, wherein each of the power pulse-spectrum charts includes a correspondence relation among temperatures, the SOC values and instantaneous powers;
S303: for the instance of the power pulse-spectrum charts corresponding to each of the electric-current impact durations, looking up from that power pulse-spectrum chart a correspondence relation between the SOC values and the instantaneous powers at the current lowest temperature, and a correspondence relation between the SOC values and the instantaneous powers at the current highest temperature; and for each of the SOC values in that power pulse-spectrum chart, selecting a smaller value between the instantaneous power at the current highest temperature and the instantaneous power at the current lowest temperature corresponding to that SOC value, to be used as the minimum power corresponding to that SOC value in that power pulse-spectrum chart; and
S304: using a minimum value among the minimum powers corresponding to the same SOC value in the plurality of power pulse-spectrum charts as the minimum power corresponding to that SOC value, to obtain the first minimum-power pulse-spectrum chart.

In the present embodiment, it can be known from FIG. 2 that, with the same impact current and the same SOC value, different temperatures correspond to different instantaneous powers, and the temperatures and the instantaneous powers do not have a constant correspondence relation therebetween that can be followed. Therefore, in the present embodiment, firstly the lower power value of the instantaneous powers corresponding to the same SOC value in the same power pulse-spectrum chart at the highest temperature and the lowest temperature is looked up, and subsequently the minimum value among the plurality of minimum powers of the same SOC value is looked up in the different power pulse-spectrum charts as the final minimum power of that SOC value, to obtain the correspondence relation between the SOC values and the minimum powers, i.e., the first minimum-power pulse-spectrum chart.

As compared with S201-S204, in the process of acquiring the first minimum-power pulse-spectrum chart given in S301-S304, the minimum power of the battery in the current temperature range is obtained by taking into consideration the current lowest temperature and the current highest temperature of the battery, thereby obtaining the available SOC window value according to the lower minimum power, which further expands the range of the available battery SOC.

In an alternative embodiment, the particular implementation process of S101 includes:
by using a formula *Pₘᵢₙ*=*Vⱼ***n***η*, calculating the corresponding target power value when the battery discharges to the cut-off voltage at a specified discharge rate;
where *Pₘᵢₙ* represents the target power value, *Vⱼ* represents an individual cut-off voltage, *n* represents a quantity of individual cell strings included by the battery, and *η* represents a discharge rate.

In the present embodiment, the discharge rate is a measurement of the speed of discharging, and refers to the electric-current value that is required by the battery to release its rated capacity within a specified duration. The specified discharge rate may be C/3, where C represents the rated capacity of the battery.

As an example, *η* is C/3.

In an embodiment, before S101, the method for determining an available SOC window value of a battery according to the present application further includes:
acquiring a current temperature of the battery;
if the current temperature of the battery is in a normal-temperature interval, then not executing S101 to S102, and directly setting the available SOC window value of the battery to be zero; and
if the current temperature of the battery is not in the normal-temperature interval, then continuing to execute S101 to S102.

Because, in the normal-temperature interval, the battery can in fact release the whole of the electric quantity, when the battery is in the normal-temperature interval, the available SOC window value is directly set to be zero, thereby expanding the available capacity of the battery at normal temperature.

As an example, the normal-temperature interval may be 22°C to 27°C.

It should be understood that the sequence of the serial numbers of the steps in the above embodiments do not indicate the sequence of the execution thereof, and the sequence of the execution of the steps should be decided according to their functions and internal logic, and should not limit the implementation of the embodiments of the present application in any manner.

The device embodiments of the present application will be described below, and the details not described in detail therein may refer to the above-described corresponding process embodiments.

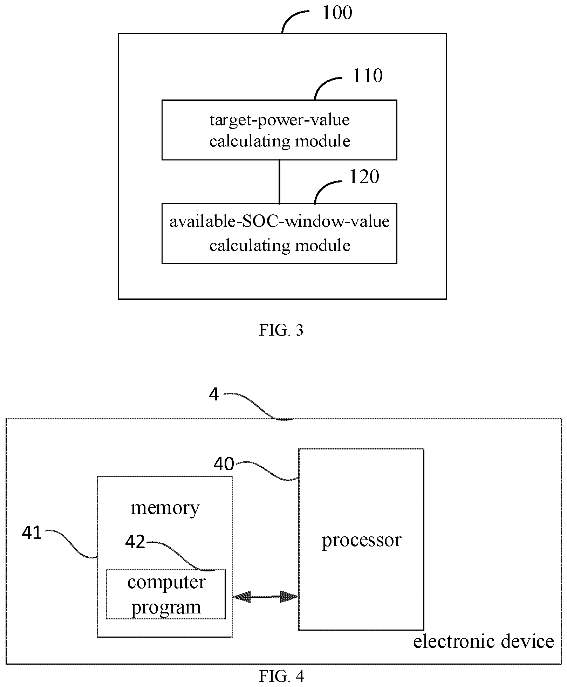

FIG. 3 shows a schematic structural diagram of an apparatus for determining an available SOC window value of a battery according to an embodiment of the present application. For the convenience of the description, merely the parts relevant to the embodiments of the present application are shown, and it will be described in detail as follows:

As shown in FIG. 3, the apparatus for determining an available SOC window value of a battery 100 includes:
a target-power-value calculating module 110 configured for calculating a corresponding power value when the battery discharges to a cut-off voltage, and using the power value as a target power value; and
an available-SOC-window-value calculating module 120 configured for looking up a minimum SOC value corresponding to the target power value in a first minimum-power pulse-spectrum chart, and using the minimum SOC value as the available SOC window value;
wherein the first minimum-power pulse-spectrum chart refers to a chart of a correspondence relation between SOC values and minimum powers, the minimum power corresponding to any one of the SOC values represents the minimum power with which the battery with that SOC value performs short-time discharging to cause a battery voltage to reach the cut-off voltage, and a time period of the short-time discharging is less than a preset duration.

In an alternative embodiment, the apparatus for determining an available SOC window value of a battery 100 further includes a first-minimum-power-pulse-spectrum-chart acquiring module configured for:
acquiring a current temperature of the battery;
acquiring power pulse-spectrum charts corresponding to a plurality of electric-current impact durations of the battery, wherein each of the power pulse-spectrum charts includes a correspondence relation among temperatures, the SOC values and instantaneous powers;
using a minimum value of the instantaneous powers corresponding to the plurality of electric-current impact durations with respect to a same temperature and a same SOC value as the minimum power corresponding to that temperature and that SOC value, to obtain a minimum-power pulse-spectrum chart; and
looking up a correspondence relation between the SOC values and the minimum powers at the current temperature in the minimum-power pulse-spectrum chart, and using the correspondence relation between the SOC values and the minimum powers at the current temperature as the first minimum-power pulse-spectrum chart.

In an alternative embodiment, the first-minimum-power-pulse-spectrum-chart acquiring module is configured for:
acquiring a current lowest temperature and a current highest temperature of the battery, wherein the current lowest temperature refers to a minimum value of current temperatures corresponding to a plurality of individual cells in the battery, and the current highest temperature refers to a maximum value of the current temperatures corresponding to the plurality of individual cells in the battery;
acquiring power pulse-spectrum charts corresponding to a plurality of electric-current impact durations of the battery, wherein each of the power pulse-spectrum charts includes a correspondence relation among temperatures, the SOC values and instantaneous powers;
for the instance of the power pulse-spectrum charts corresponding to each of the electric-current impact durations, looking up from that power pulse-spectrum chart a correspondence relation between the SOC values and the instantaneous powers at the current lowest temperature, and a correspondence relation between the SOC values and the instantaneous powers at the current highest temperature;
for each of the SOC values in that power pulse-spectrum chart, selecting a smaller value between the instantaneous power at the current highest temperature and the instantaneous power at the current lowest temperature corresponding to that SOC value, to be used as the minimum power corresponding to that SOC value in that power pulse-spectrum chart; and
using a minimum value among the minimum powers corresponding to the same SOC value in the plurality of power pulse-spectrum charts as the minimum power corresponding to that SOC value, to obtain the first minimum-power pulse-spectrum chart.

In an alternative embodiment, the target-power-value calculating module 110 is configured for:
by using a formula *Pₘᵢₙ*=*Vⱼ***n***η*, calculating the target power value;
wherein *Pₘᵢₙ* represents the target power value, *Vⱼ* represents an individual cut-off voltage, *n* represents a quantity of individual cell strings included by the battery, and *η* represents a discharge rate.

In an alternative embodiment, the apparatus further includes a temperature determining module configured for:
acquiring a current temperature of the battery;
if the current temperature of the battery is in a normal-temperature interval, setting the available SOC window value of the battery to be zero; and
if the current temperature of the battery is not in the normal-temperature interval, executing the functions of the target-power-value calculating module 110 and the available-SOC-window-value calculating module 120.

It can be known from the above embodiments that, because the correspondence relation between the minimum powers and the SOC values in the minimum-power pulse-spectrum chart is determined by determining whether the battery, after short-time discharging with a certain SOC value with the minimum power, has reached the cut-off voltage, and the maximum available capacity refers to the whole electric quantity that can be released when, by using an electric-current of a constant discharge rate, the battery has been discharged continuously from the full-electricity state till the battery voltage reaches the discharging cut-off voltage, as compared with the method of calculating the available SOC window value based on the maximum available capacity, the method according to the present embodiment, by using the instantaneous power impact, generally can enable the battery to release more electric quantity. Therefore, in order to enable the battery to release the maximum electric quantity while ensuring the safety of the battery, in the present embodiment, the available SOC window value of the battery is obtained based on the minimum-power pulse-spectrum chart, which can increase the releasable electric quantity of the battery while ensuring the safety of the battery, to improve the endurance capacity of the battery, and optimize the user experience.

An embodiment of the present application further provides a computer program product, wherein the computer program product has a program code, and the program code, when executed in a corresponding processor, controller, computing device or electronic device, implements the steps of any one of the above embodiments of the method for determining an available SOC window value of a battery, for example, the step S101 to the step S102 shown in FIG. 1. A person skilled in the art should understand that the method and the device according to the embodiments of the present application may be embodied in various forms of hardware, software, firmware, dedicated processors or a combination thereof. The dedicated processors may include an Application Specific Integrated Circuit (ASIC), a Reduced Instruction-Set Computer (RISC) and/or a Field-Programmable Gate Array (FPGA). The method and the device are preferably embodied as a combination of hardware and software. The software is preferably installed in a program storage device as an application program. It is typically a machine based on a computer platform having hardware, for example, one or more central processing units (CPU), a Random Access Memory (RAM) and one or more inputting/outputting (I/O) interfaces. The operating system is typically also installed in the computer platform. The processes and the functions described herein may be part of the application program, or part of them may be performed by the operating system.

FIG. 4 is a schematic diagram of an electronic device according to an embodiment of the present application. As shown in FIG. 4, the electronic device 4 according to the present embodiment includes a processor 40, a memory 41, and a computer program 42 that is stored in the memory 41 and executable in the processor 40. The processor 40, when executing the computer program 42, implements the steps of the above embodiments of the method for determining an available SOC window value of a battery, for example, the step S101 to the step S102 shown in FIG. 1. Alternatively, the processor 40, when executing the computer program 42, implements the functions of the modules/units according to the above device embodiments, for example, the functions of the target-power-value calculating module 110 to the available-SOC-window-value calculating module 120 shown in FIG. 3.

As an example, the computer program 42 may be divided into one or more modules/units, and the one or more modules/units are stored in the memory 41, and are executed by the processor 40, to complete/implement the solutions according to the present application. The one or more modules/units may be a series of computer program instruction segments that can complete specific functions, and the instruction segments are used to describe the process of the execution of the computer program 42 in the electronic device 4. For example, the computer program 42 may be divided into the target-power-value calculating module 110 to the available-SOC-window-value calculating module 120 shown in FIG. 4.

The electronic device 4 may include, without limitation, a processor 40 and a memory 41. A person skilled in the art can understand that FIG. 4 is merely an example of the electronic device 4, and does not limit the electronic device 4, and the electronic device 4 may include more or fewer components than those shown in the figure, or a combination of some of the components, or different components. For example, the electronic device may further include an inputting-outputting device, a network accessing device, a bus and so on.

The processor 40 may be a Central Processing Unit (CPU), and may also be another generic processor, Digital Signal Processor (DSP), Application Specific Integrated Circuit (ASIC), Field-Programmable Gate Array (FPGA) or another programmable logic device, discrete gate or transistor logic device, discrete hardware assembly and so on. The generic processor may be a microprocessor, and the processor may also be any conventional processor.

The memory 41 may be an internal storage unit of the electronic device 4, for example, a hard disk or an internal memory of the electronic device 4. The memory 41 may also be an external storage device of the electronic device 4, for example, a plug-connected hard disk, a Smart Media Card (SMC), a Secure Digital (SD) card, a Flash Card, and so on, that the electronic device 4 is equipped with. Further, the memory 41 may also include not only the internal storage unit of the electronic device 4 but also the external storage device. The memory 41 is configured to store the computer program, and other programs and data that are required by the electronic device. The memory 41 may also be configured to temporarily store the data that have already been outputted or will be outputted.

A person skilled in the art can clearly understand that, in order for convenience and brevity of the description, the division of the above functional units and modules is merely taken as an example for the description. In practical applications, the above functions may be allocated to be completed by different functional units and modules according to demands, i.e., dividing the internal structure of the apparatus into different functional units or modules, to complete all or some of the functions described above. The functional units and modules according to the embodiments may be integrated into one processing unit, or the units may also separately physically exist, or two or more of the units may also be integrated into one unit. The above-described integrated unit may be embodied in the form of hardware, and may also be embodied in the form of a software function unit. In addition, the particular names of the functional units and modules are merely for the convenience of distinguishing from each other, and are not intended to limit the protection scope of the present application. The particular working processes of the units and modules in the above-described system may refer to the corresponding processes according to the above-described process embodiments, and are not discussed further herein.

In the above embodiments, the descriptions on the embodiments have respective emphases, and the parts of a certain embodiment that are not described or set forth in detail may refer to the relevant descriptions on the other embodiments.

A person skilled in the art can envisage that the units and the algorithm steps of the examples described with reference to the embodiments disclosed herein may be implemented by using electronic hardware or a combination of computer software and electronic hardware. Whether those functions are executed by hardware or software depends on the particular applications and the design constraints of the technical solutions. A person skilled in the art may employ different methods to implement the described functions with respect to each of the particular applications, but the implementations should not be considered as extending beyond the scope of the present application.

In the embodiments of the present application, it should be understood that the disclosed apparatus/electronic device and method may be implemented in other manners. For example, the above-described device/electronic device embodiments are merely illustrative. For example, the division between the modules/units is merely a division in the logic functions, and in the practical implementation there may be another mode of division. For example, multiple units or components may be combined or may be integrated into another system, or some of the features may be omitted, or not implemented. Additionally, the coupling or direct coupling or communicative connection between the illustrated or discussed components may be via interfaces or the indirect coupling or communicative connection between the devices or units, and may be electric, mechanical or in other forms.

The units that are described as separate components may or may not be physically separate, and the components that are displayed as units may or may not be physical units; in other words, they may be located at the same one location, and may also be distributed to a plurality of network units. Some or all of the units may be selected according to practical demands to realize the purposes of the solutions of the embodiments.

Furthermore, the functional units according to the embodiments of the present application may be integrated into one processing unit, or the units may also separately physically exist, or two or more of the units may also be integrated into one unit. The above-described integrated unit may be embodied in the form of hardware, and may also be embodied in the form of a software function unit.

The integrated modules/units, if embodied in the form of software function units and sold or used as an independent product, may be stored in a computer-readable storage medium. On the basis of such a comprehension, all or some of the processes of the methods according to the embodiments of the present application may be implemented by relative hardware according to an instruction from a computer program, the computer program may be stored in a computer-readable storage medium, and the computer program, when executed by a processor, can implement the steps of the above embodiments of the method for determining an available SOC window value of a battery. The computer program includes a computer program code, and the computer program code may be a source code, an object code, an executable file, some intermediate forms, and so on. The computer-readable medium may include any entity or device that can carry the computer program code, including a recording medium, a USB flash disk, a mobile hard disk drive, a diskette, an optical disk, a computer memory, a Read-Only Memory (ROM), a Random Access Memory (RAM), an electric carrier signal, a telecommunication signal, a software distribution medium and so on. It should also be noted that the contents included by the computer-readable medium may be properly added or removed according to the requirements by the practices of the legislation and the patent within jurisdictions. For example, within certain jurisdictions, according to the practices of the legislation and the patent, the computer-readable medium does not include an electric carrier signal and a telecommunication signal.

The present embodiment provides a vehicle, wherein the vehicle includes the electronic device 4 stated above.

In addition, the embodiments shown in the drawings of the present application or the features of the embodiments described in the description are not required to be understood as mutually independent embodiments. Instead, each of the features described in one of the examples of one embodiment may be combined with one or more other desired features from the other embodiments, thereby generating another embodiment not described in the texts or with reference to the drawings.

The above embodiments are merely intended to describe the technical solutions of the present application, and not to limit them. Although the present application is explained in detail with reference to the above embodiments, a person skilled in the art should understand that he can still modify the technical solutions set forth by the above embodiments, or make equivalent substitutions to part of the technical features of them. However, those modifications or substitutions do not make the essence of the corresponding technical solutions depart from the spirit and scope of the technical solutions of the embodiments of the present application, and all of them should fall within the protection scope of the present application.

## Claims

1. A method for determining an available SOC window value of a battery, **characterized in that** the method comprises:
calculating a corresponding power value when the battery discharges to a cut-off voltage, and using the power value as a target power value; and
looking up a minimum SOC value corresponding to the target power value in a first minimum-power pulse-spectrum chart, and using the minimum SOC value as the available SOC window value of the battery;
wherein the first minimum-power pulse-spectrum chart refers to a chart of a correspondence relation between SOC values and minimum powers, the minimum power corresponding to any one of the SOC values represents the minimum power with which the battery with that SOC value performs short-time discharging to cause a battery voltage to reach the cut-off voltage, and a time period of the short-time discharging is less than a preset duration.

2. The method for determining the available SOC window value of the battery according to claim 1, **characterized in that** the first minimum-power pulse-spectrum chart is acquired by:
acquiring a current temperature of the battery;
acquiring power pulse-spectrum charts corresponding to a plurality of electric-current impact durations of the battery, wherein each of the power pulse-spectrum charts comprises a correspondence relation among temperatures, the SOC values and instantaneous powers;
using a minimum value of the instantaneous powers corresponding to the plurality of electric-current impact durations with respect to a same temperature and a same SOC value as the minimum power corresponding to that temperature and that SOC value, to obtain a minimum-power pulse-spectrum chart; and
looking up a correspondence relation between the SOC values and the minimum powers at the current temperature in the minimum-power pulse-spectrum chart, and using the correspondence relation between the SOC values and the minimum powers at the current temperature as the first minimum-power pulse-spectrum chart.

3. The method for determining the available SOC window value of the battery according to claim 2, **characterized in that** the instantaneous powers are acquired by:
when the battery is at a same temperature and a same SOC value, discharging the battery at a plurality of unequal powers for the plurality of electric-current impact durations, and using powers that are capable of impacting the battery voltage to a discharging cut-off voltage as the instantaneous powers corresponding to the plurality of electric-current impact durations at that temperature and that SOC value.

4. The method for determining the available SOC window value of the battery according to claim 1, **characterized in that** the first minimum-power pulse-spectrum chart is acquired by:
acquiring a current lowest temperature and a current highest temperature of the battery, wherein the current lowest temperature refers to a minimum value of current temperatures corresponding to a plurality of individual cells in the battery, and the current highest temperature refers to a maximum value of the current temperatures corresponding to the plurality of individual cells in the battery;
acquiring power pulse-spectrum charts corresponding to a plurality of electric-current impact durations of the battery, wherein each of the power pulse-spectrum charts comprises a correspondence relation among temperatures, the SOC values and instantaneous powers;
for the instance of the power pulse-spectrum charts corresponding to each of the electric-current impact durations, looking up from that power pulse-spectrum chart a correspondence relation between the SOC values and the instantaneous powers at the current lowest temperature, and a correspondence relation between the SOC values and the instantaneous powers at the current highest temperature;
for each of the SOC values **in that** power pulse-spectrum chart, selecting a smaller value between the instantaneous power at the current highest temperature and the instantaneous power at the current lowest temperature corresponding to that SOC value, to be used as the minimum power corresponding to that SOC value **in that** power pulse-spectrum chart; and
using a minimum value among the minimum powers corresponding to a same SOC value in the plurality of power pulse-spectrum charts as the minimum power corresponding to that SOC value, to obtain the first minimum-power pulse-spectrum chart.

5. The method for determining the available SOC window value of the battery according to claim 1, **characterized in that** the step of calculating the corresponding power value when the battery discharges to the cut-off voltage, and using the power value as the target power value comprises:
by using a formula *Pₘᵢₙ*=*Vⱼ***n***η*, calculating the target power value;
wherein *Pₘᵢₙ* represents the target power value, *Vⱼ* represents an individual cut-off voltage, *n* represents a quantity of individual cell strings comprised by the battery, and *η* represents a discharge rate.

6. The method for determining the available SOC window value of the battery according to claim 1, **characterized in that** before the step of calculating the corresponding power value when the battery discharges to the cut-off voltage, the method further comprises:
acquiring a current temperature of the battery;
if the current temperature of the battery is in a normal-temperature interval, setting the available SOC window value of the battery to be zero; and
if the current temperature of the battery is not in the normal-temperature interval, executing the step of calculating the corresponding power value when the battery discharges to the cut-off voltage.

7. The method for determining the available SOC window value of the battery according to claim 1, **characterized in that** the step of looking up the minimum SOC value corresponding to the target power value in the first minimum-power pulse-spectrum chart, and using the minimum SOC value as the available SOC window value of the battery comprises:
when a minimum power equal to the target power value is not capable to be found in the first minimum-power pulse-spectrum chart, selecting a SOC value corresponding to a minimum power that has a lowest difference from the target power value, to be used as the available SOC window value corresponding to the target power value.

8. The method for determining the available SOC window value of the battery according to claim 1, **characterized in that** the step of looking up the minimum SOC value corresponding to the target power value in the first minimum-power pulse-spectrum chart, and using the minimum SOC value as the available SOC window value of the battery comprises:
when a minimum power equal to the target power value is not capable to be found in the first minimum-power pulse-spectrum chart, selecting an average value of the SOC values corresponding to two minimum powers adjacent to the target power value, to be used as the available SOC window value corresponding to the target power value.

9. An apparatus for determining an available SOC window value of a battery, **characterized in that** the apparatus comprises:
a target-power-value calculating module configured for calculating a corresponding power value when the battery discharges to a cut-off voltage, and using the power value as a target power value; and
an available-SOC-window-value calculating module configured for looking up a minimum SOC value corresponding to the target power value in a first minimum-power pulse-spectrum chart, and using the minimum SOC value as the available SOC window value;
wherein the first minimum-power pulse-spectrum chart refers to a chart of a correspondence relation between SOC values and minimum powers, the minimum power corresponding to any one of the SOC values represents the minimum power with which the battery with that SOC value performs short-time discharging to cause a battery voltage to reach the cut-off voltage, and a time period of the short-time discharging is less than a preset duration.

10. The apparatus for determining the available SOC window value of the battery according to claim 9, **characterized in that** the apparatus further comprises a first-minimum-power-pulse-spectrum-chart acquiring module configured for:
acquiring a current temperature of the battery;
acquiring power pulse-spectrum charts corresponding to a plurality of electric-current impact durations of the battery, wherein each of the power pulse-spectrum charts comprises a correspondence relation among temperatures, the SOC values and instantaneous powers;
using a minimum value of the instantaneous powers corresponding to the plurality of electric-current impact durations with respect to a same temperature and a same SOC value as the minimum power corresponding to that temperature and that SOC value, to obtain a minimum-power pulse-spectrum chart; and
looking up a correspondence relation between the SOC values and the minimum powers at the current temperature in the minimum-power pulse-spectrum chart, and using the correspondence relation between the SOC values and the minimum powers at the current temperature as the first minimum-power pulse-spectrum chart.

11. The apparatus for determining the available SOC window value of the battery according to claim 9, **characterized in that** the apparatus further comprises a first-minimum-power-pulse-spectrum-chart acquiring module configured for:
acquiring a current lowest temperature and a current highest temperature of the battery, wherein the current lowest temperature refers to a minimum value of current temperatures corresponding to a plurality of individual cells in the battery, and the current highest temperature refers to a maximum value of the current temperatures corresponding to the plurality of individual cells in the battery;
acquiring power pulse-spectrum charts corresponding to a plurality of electric-current impact durations of the battery, wherein each of the power pulse-spectrum charts comprises a correspondence relation among temperatures, the SOC values and instantaneous powers;
for the instance of the power pulse-spectrum charts corresponding to each of the electric-current impact durations, looking up from that power pulse-spectrum chart a correspondence relation between the SOC values and the instantaneous powers at the current lowest temperature, and a correspondence relation between the SOC values and the instantaneous powers at the current highest temperature;
for each of the SOC values **in that** power pulse-spectrum chart, selecting a smaller value between the instantaneous power at the current highest temperature and the instantaneous power at the current lowest temperature corresponding to that SOC value, to be used as the minimum power corresponding to that SOC value **in that** power pulse-spectrum chart; and
using a minimum value among the minimum powers corresponding to a same SOC value in the plurality of power pulse-spectrum charts as the minimum power corresponding to that SOC value, to obtain the first minimum-power pulse-spectrum chart.

12. The apparatus for determining the available SOC window value of the battery according to claim 9, **characterized in that** the target-power-value calculating module is configured for:
by using a formula *Pₘᵢₙ*=*Vⱼ***n***η*, calculating the target power value;
wherein *Pₘᵢₙ* represents the target power value, *Vⱼ* represents an individual cut-off voltage, *n* represents a quantity of individual cell strings comprised by the battery, and *η* represents a discharge rate.

13. An electronic device, comprising a memory, a processor, and a computer program that is stored in the memory and executable in the processor, **characterized in that** the processor, when executing the computer program, implements the steps of the method for determining the available SOC window value of the battery according to any one of claims 1 to 8.

14. A computer-readable storage medium, the computer-readable storage medium storing a computer program, **characterized in that** the computer program, when executed by a processor, implements the steps of the method for determining the available SOC window value of the battery according to any one of claims 1 to 8.

15. A vehicle, wherein the vehicle comprises the electronic device according to claim 13.
